Europäisches Patentamt

European Patent Office

Office européen des brevets

(19)

(11)  EP 0 779 703 B1

(12)  **FASCICULE DE BREVET EUROPEEN**

(45) Date de publication et mention
de la délivrance du brevet:
**19.07.2000  Bulletin 2000/29**

(51) Int Cl.⁷: **H03D 3/06**

(21) Numéro de dépôt: **96402667.8**

(22) Date de dépôt: **09.12.1996**

(54) **Circuit démodulateur pour un signal à fréquence modulée autour d'une fréquence intermédiaire**

Demodulatorschaltung für frequenzmoduliertes Signal in der Nähe einer Zwischenfrequenz

Demodulator circuit for a signal, frequency modulated near an intermediate frequency

(84) Etats contractants désignés:
**AT BE CH DE FI GB IT LI NL SE**

(30) Priorité: **12.12.1995  FR 9514708**

(43) Date de publication de la demande:
**18.06.1997  Bulletin 1997/25**

(73) Titulaire: **MATRA NORTEL COMMUNICATIONS**
**29000 Quimper (FR)**

(72) Inventeurs:
• **Guegnaud, Hervé**
**78390 Maurepas (FR)**

• **Robbe, Michel**
**78700 Conflans Sainte Honorine (FR)**

(74) Mandataire: **Loisel, Bertrand**
**Cabinet Plasseraud,**
**84, rue d'Amsterdam**
**75440 Paris Cédex 09 (FR)**

(56) Documents cités:
**EP-A- 0 162 525          WO-A-95/27340**
**US-A- 4 455 539**

• **PATENT ABSTRACTS OF JAPAN vol. 009, no. 089 (E-309), 18 Avril 1985 & JP 59 219005 A (PIONEER KK), 10 Décembre 1984,**

**Description**

La présente invention telle qu'elle est définie dans les revendications concerne un démodulateur pour un signal radio à modulation de fréquence. L'invention s'applique plus particulièrement à la démodulation des signaux radio dont la fréquence a déjà été ramenée autour d'une fréquence intermédiaire $f_I$.

On considère un signal d'entrée de fréquence $f = f_I + \Delta f$, l'écart de fréquence $\Delta f$ étant représentatif d'une information transportée par le signal. Pour démoduler un tel signal d'entrée, on utilise généralement un mélangeur qui multiplie ce signal $\cos(2\pi ft)$ par une version déphasée $\cos(2\pi ft + \varphi(\Delta f))$ de ce même signal, le déphasage $\varphi(\Delta f)$ variant linéairement avec l'écart de fréquence $\Delta f$. Le signal mélangé est alors proportionnel à $\cos(4\pi ft + \varphi(\Delta f)) + \cos(\varphi(\Delta f))$. Le premier terme est éliminé par un filtre passe-bas. Le signal de sortie de ce filtre passe-bas est donc proportionnel à $\cos\varphi(\Delta f)$, de sorte que c'est un signal en bande de base représentatif de la modulation de fréquence $\Delta f$.

Lorsqu'on souhaite réaliser le démodulateur sous la forme d'un circuit intégré, il reste nécessaire d'utiliser un pôle externe pour introduire le déphasage $\varphi(\Delta f)$. Ce pôle externe est constitué par un filtre céramique ou par un élément ajustable par un noyau de ferrite. Les principaux inconvénients de ces démodulateurs connus sont la nécessité d'un composant externe, les ajustements fréquents qu'il requiert, une distorsion non négligeable, et l'utilisation d'une broche externe du circuit intégré. Le document EP-A-0 162 525 divulgue un exemple d'un tel démodulateur.

Un but de la présente invention est de proposer un démodulateur entièrement réalisable sous la forme d'un circuit intégré, et qui soit moins affecté par les inconvénients ci-dessus.

L'invention propose ainsi un circuit démodulateur pour traiter un signal d'entrée présentant une modulation de fréquence autour d'une fréquence intermédiaire et produire un signal de sortie en bande de base représentatif de ladite modulation, comprenant :

des premiers moyens de mélange entre le signal d'entrée et une onde de fréquence prédéterminée pour produire un premier signal présentant ladite modulation de fréquence autour d'une fréquence de transposition égale à la différence entre la fréquence intermédiaire et ladite fréquence prédéterminée ;

des moyens déphaseurs à capacités commutées auxquels est appliqué le premier signal, pour produire un second signal présentant, par rapport au premier signal, un déphasage variant de façon sensiblement linéaire avec la fréquence autour de la fréquence de transposition ;

un premier filtre passe-bas auquel est appliqué le second signal pour éliminer des composantes à haute fréquence du second signal ;

un second filtre passe-bas sensiblement identique au premier filtre passe-bas, auquel est appliqué le premier signal ; et

des seconds moyens de mélange entre des signaux respectivement produits par les premier et second filtres passe-bas pour délivrer le signal de sortie en bande de base.

L'utilisation de filtres à capacités commutées pour produire le déphasage variant linéairement avec l'écart de fréquence présente de nombreux avantages. Ainsi, le filtre déphaseur peut être intégré avec le reste du circuit. En outre, les paramètres du filtre sont bien maîtrisés, de sorte qu'on peut se dispenser des réglages externes nécessaires dans les démodulateurs antérieurs. Le déphaseur à capacités commutées peut être d'ordre supérieur au filtre déphaseur externe utilisé dans les démodulateurs antérieurs (typiquement des résonateurs LC d'ordre 1), de sorte qu'on peut construire un déphaseur présentant une excellente linéarité de phase grâce à une faible ondulation du temps de propagation de groupe dans la bande passante. On utilise de préférence pour les moyens déphaseurs à capacités commutées deux cellules d'ordre 2 à capacités commutées en série, à savoir une cellule de filtrage passe-bas et une cellule de filtrage passe-bande.

L'application du déphasage résultant d'un dispositif à capacités commutées, la fréquence centrale du signal adressé à ce dispositif doit être beaucoup plus basse que la fréquence d'échantillonnage du dispositif, laquelle est typiquement de quelques MHz. C'est pourquoi les premiers moyens de mélange sont prévus pour abaisser la fréquence centrale du signal.

Le premier filtre passe-bas sert à éliminer du signal déphasé des composantes résiduelles à haute fréquence dues à la fréquence d'échantillonnage dans le dispositif à capacités commutées ou à ses harmoniques. Ce premier filtre passe-bas introduisant également un certain déphasage, le second filtre, de caractéristiques aussi proches que possible, est utilisé pour filtrer le premier signal avant qu'il soit mélangé au signal déphasé et filtré.

D'autres particularités et avantages de la présente invention apparaîtront dans la description ci-après d'un exemple de réalisation non limitatif, en référence aux dessins annexés, dans lesquels :

- la figure 1 est un schéma d'un circuit démodulateur selon l'invention ;
- la figure 2 est un schéma d'un multiplieur du circuit de la figure 1 ;
- la figure 3 est un schéma d'un filtre passe-bas du circuit de la figure 1 ;
- les figures 4 et 5 sont des schémas d'un filtre passe-bas et d'un filtre passe-bande à capacités commutées du circuit de la figure 1 ; et
- la figure 6 est un schéma d'un autre multiplieur du circuit de la figure 1.

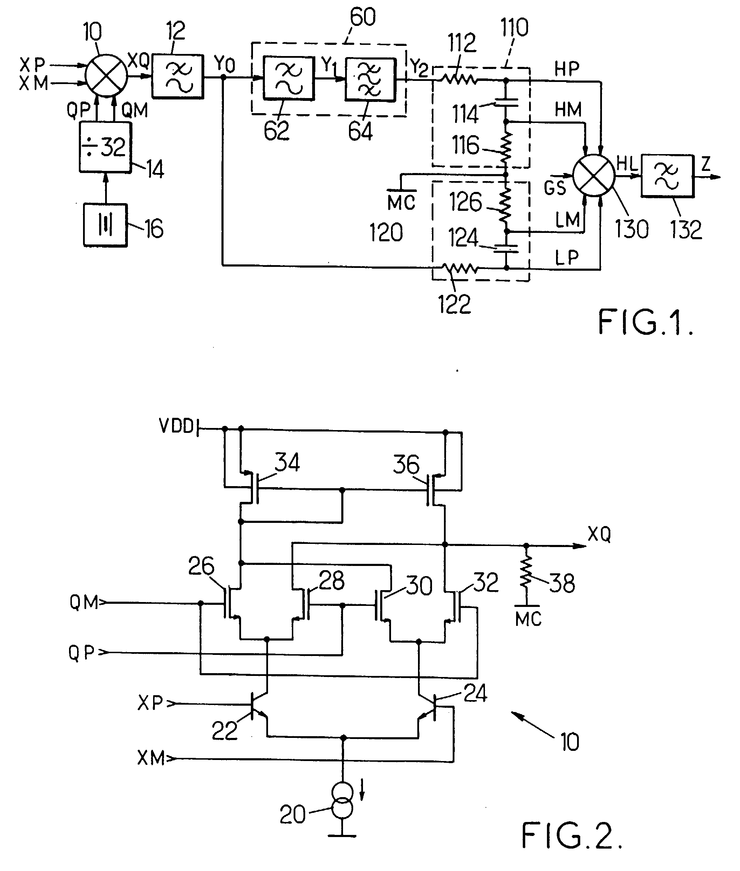

Le démodulateur de la figure 1 comprend des premiers moyens de mélange constitués par un multiplieur 10 associé à un filtre passe-bas 12. Le signal d'entrée du circuit est disponible sous forme de deux signaux de tension différentiels XP, XM=-XP.

Outre les signaux de tension XP, XM, le multiplieur 10 reçoit deux autres signaux de tension différentiels QP, QP, QM=-QP représentant une onde de fréquence $f_0$. Cette onde est produite par un diviseur de fréquence 14 à partir d'un signal produit à une fréquence de référence par un oscillateur à quartz 16.

Dans l'exemple considéré ici, la fréquence intermédiaire $f_I$ est de 450 kHz, et la fréquence de l'onde QP, QM est de 348,44 kHz. Cette fréquence $f_0$ est obtenue en divisant par 32 la fréquence du quartz 16 qui est de 11,15 MHz.

Le filtre passe-bas 12 élimine du signal de sortie XQ du multiplieur 10, les composantes de fréquence voisine de $f_I+f_0$, pour ne laisser dans le signal Y0 que les composantes voisines de la fréquence de transposition $f_T=f_I-f_0=102,56$ kHz.

Le multiplieur 10 a par exemple la structure d'une cellule de Gilbert, comme représenté sur la figure 2. Un générateur de courant 20 délivrant un courant constant est connecté entre la masse et les émetteurs de deux transistors npn 22, 24. La base du transistor 22 reçoit le signal de tension XP, tandis que la base du transistor 24 reçoit le signal de tension XM=-XP. Le second étage de la cellule de Gilbert est constitué par quatre transistors NMOS 26, 28, 30, 32. Les sources des transistors NMOS 26, 28 sont reliées au collecteur du transistor npn 22, tandis que les sources des transistors NMOS 30, 32 sont reliées au collecteur du transistor npn 24. Les grilles des transistors NMOS 28, 30 reçoivent le signal de tension QP, tandis que les grilles des transistors NMOS 26, 32 reçoivent le signal de tension QM. Le multiplieur comprend encore un miroir PMOS se composant de deux transistors PMOS 34, 36 ayant leurs sources reliées à une tension positive d'alimentation VDD. Le drain du transistor 34 est relié aux drains des transistors NMOS 26, 30, tandis que le drain du transistor PMOS 36 est relié aux drains des transistors NMOS 28, 32. Les grilles des transistors PMOS 34, 36 sont également reliés aux drains des transistors NMOS 26, 28. La tension de sortie XQ du mélangeur est disponible sur les drains des transistors NMOS 28, 32 qui sont reliés, par l'intermédiaire d'une résistance 38, à une borne se trouvant à un potentiel de référence MC (par exemple la masse).

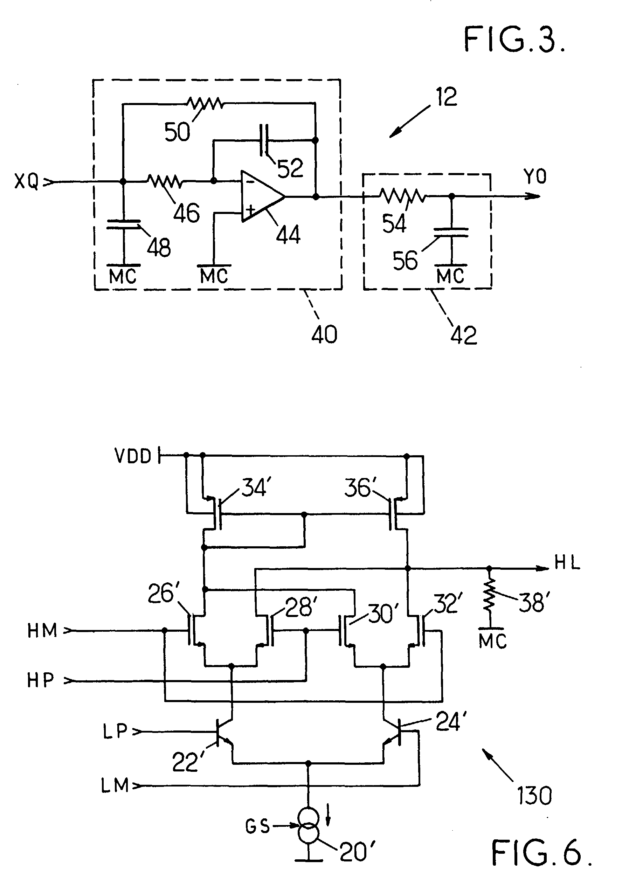

Le filtre passe-bas 12 est de préférence d'ordre au moins égal à 3. Ce filtre 12 réduit le spectre du signal pour limiter les produits d'intermodulation afin de ne pas perturber le dispositif à capacités commutées. La figure 3 montre un filtre 12 d'ordre 3 composé d'une cellule de Rausch simplifiée 40 et d'un réseau RC passe-bas 42. La cellule 40 comprend un amplificateur opérationnel 44 dont l'entrée positive est reliée au potentiel MC et l'entrée négative est reliée, par l'intermédiaire d'une résistance 46 à l'entrée du filtre recevant le signal de tension XQ. L'entrée du filtre est également reliée au potentiel MC par l'intermédiaire d'un condensateur 48, et à la sortie de l'amplificateur opérationnel 44 par l'intermédiaire d'une résistance 50. Un condensateur d'intégration 52 relie l'entrée négative et la sortie de l'amplificateur opérationnel 44. Le réseau RC 42 comprend une résistance 54 reliant la sortie de l'amplificateur opérationnel 44 à la sortie du filtre 12 où est disponible le signal de tension Y0, et un condensateur 56 connecté entre le potentiel MC et la sortie du filtre.

En règle générale, la fréquence intermédiaire $f_I$ est comprise entre 440 et 500 kHz. On choisit alors une fréquence de transposition $f_T$ comprise entre 200 et 300 kHz. Ce choix de la fréquence de transposition $f_T$ qui sera la fréquence centrale des filtres déphaseurs résulte d'un compromis :

- la fréquence centrale des filtres déphaseurs doit rester grande devant l'excursion en fréquence $\Delta f_{max}$ (telle que $-\Delta f_{max}<\Delta f<+\Delta f_{max}$) pour conserver une phase linéaire dans la bande passante ;
- d'autre part, l'écart entre $f_I-f_0$ et $f_I+f_0$ doit être suffisamment grand pour obtenir un bon filtrage de la raie parasite présente autour de $f_I+f_0$.

Par ailleurs, le filtrage déphaseur étant à capacités commutées, la fréquence centrale doit être largement inférieure à la fréquence d'échantillonnage qui est de quelques MHz. Dans ces conditions, on dimensionne avantageusement les composants du filtre passe-bas 12 pour que ce filtre ait une fréquence de coupure comprise entre 200 et 300 kHz.

On a vu que, dans l'exemple considéré, la fréquence de transposition $f_T$ est de 102, 56 kHz pour une fréquence intermédiaire $f_I$ de 450 kHz. La fréquence de coupure du filtre 12 est alors par exemple de l'ordre de 240 kHz, ce qui peut être obtenu avec une cellule active 40 ayant une fréquence de coupure de 263 kHz et un coefficient de surtension de 0,687 et un réseau RC 42 ayant une fréquence de coupure de 284 kHz.

Ces valeurs sont par exemple obtenues avec le dimensionnement suivant : $R_{46}=68$ k$\Omega$, $C_{48}=16$ pF, $R_{50}=42$ k$\Omega$, $C_{52}=8$ pF, $R_{54}=35$ k$\Omega$, $C_{56}=16$ pF, $R_i$ désignant la valeur ohmique de la résistance portant la référence i, et $C_j$ désignant la capacité du condensateur portant la référence j.

Le démodulateur représenté sur la figure 1 comprend des moyens déphaseurs à capacités commutées 60 auquel est appliqué le signal de sortie Y0 du filtre passe-bas 12. Ces moyens déphaseurs 60 comprennent deux cellules de filtrage à capacités commutées montées en série, à savoir une cellule passe-bas 62 d'ordre 2 et une cellule passe-bande 64 d'ordre 2. Ces deux cellules de filtrage sont commandées par deux signaux d'horloge H1, H2 à la fréquence d'échantillonnage. La fréquence d'échantillonnage est obtenue par division de fréquence à partir de l'oscillateur à quartz 16. La fréquence d'échantillonnage est par exemple de 2,7875 MHz=11,15 MHz/4. Les signaux d'horloge H1, H2 sont non recouvrants, c'est-à-dire qu'ils ne sont jamais actifs en même temps.

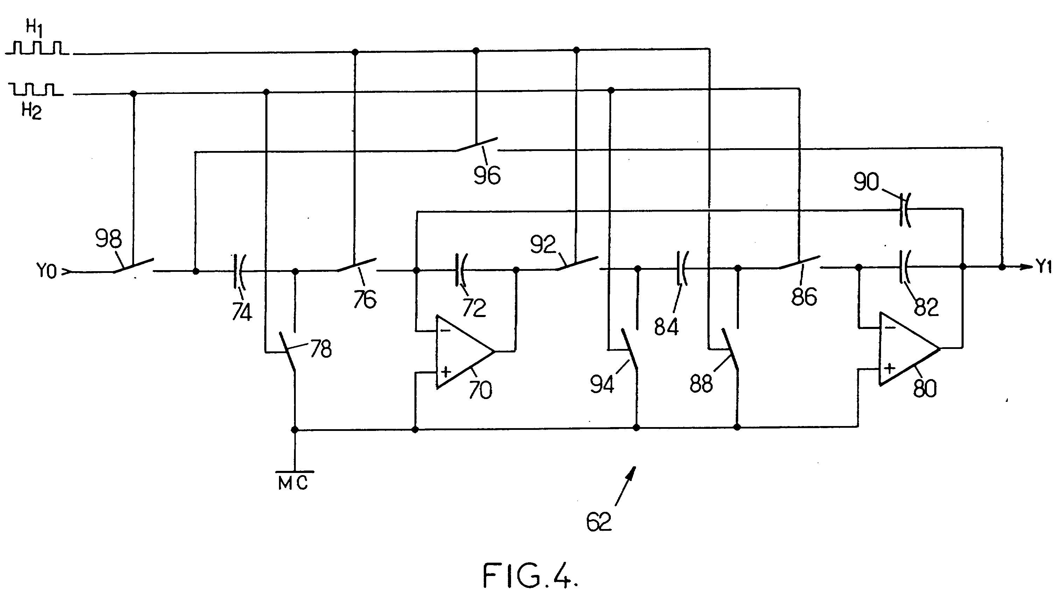

La cellule passe-bas 62 a par exemple la structure représentée sur la figure 4. Cette structure comprend deux amplificateurs opérationnels 70, 80 ayant leurs entrées positives connectées au potentiel MC. Chaque amplificateur 70, 80 est associé à un condensateur d'intégration respectif 72, 82 et à un condensateur de charge respectif 74, 84. Chaque condensateur d'intégration 72, 82 relie la sortie de son amplificateur associé à son entrée négative. Un commutateur respectif 76, 86 est monté entre l'entrée négative de chaque amplificateur opérationnel 70, 80 et une borne de son conden-sateur de charge associé 74, 84. Ces mêmes bornes des conden-sateurs de charge 74, 84 sont en outre reliées au potentiel MC par l'intermédiaire de commutateurs respectifs 78, 88. Un autre condensateur 90 relie l'entrée négative de l'amplificateur opérationnel 70 à la sortie de l'amplificateur opérationnel 80. Un commutateur 92 est monté entre la sortie de l'amplifi-cateur 70 et l'autre borne du condensateur 84. Un commutateur 94 est monté entre cette autre borne du condensateur 84 et la borne de référence au potentiel MC. Un condensateur 96 est monté entre l'autre borne du condensateur de charge 74 et la sortie de l'amplificateur opérationnel 80 constituant la sortie de la cellule, où est délivré un signal de tension Y1. Enfin, un commutateur 98 relie cette autre borne du condensateur de charge 74 à l'entrée de la cellule recevant le signal de Les tension Y0. commutateurs 76, 88, 92, 96 sont commandés par le signal d'horloge H1 de manière à être fermés uniquement lorsque le signal H1 est actif (par exemple H1=1). Les commutateurs 78, 86, 94, 98 sont commandés par l'autre signal d'horloge H2 de manière à être fermés uniquement lorsque le signal H2 est actif (H2=1).

Une telle cellule passe-bas à capacités commutées a une fonction de transfert de la forme

$$H_{LP}(z) = \frac{-C_{W1}^2}{1+(-2+C_{W1}C_{Q1}+C_{W1}^2)z+(1-C_{W1}C_{Q1})z^2}$$

où $C_{W1}$ représente la capacité des condensateurs de charge 74, 84, et $C_{Q1}$ représente la capacité du condensateur 90. Ces capacités $C_{W1}, C_{Q1}$ s'entendent comme étant normalisées relativement à la capacité des condensateurs d'intégration 72, 82.

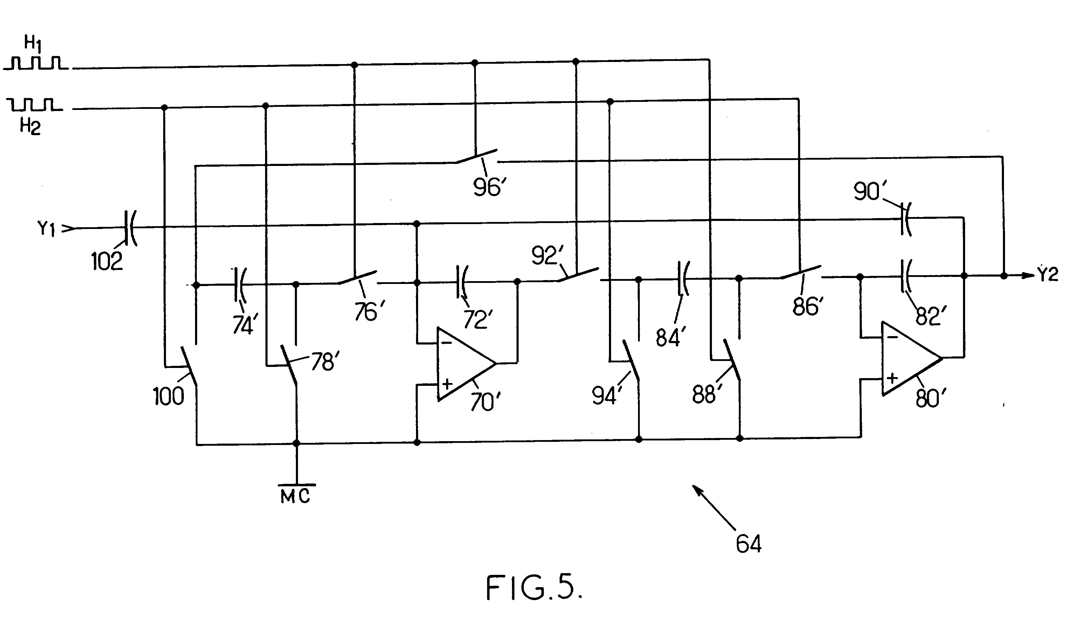

La cellule passe-bande 64 a par exemple la structure illustrée sur la figure 5. Cette structure est en grande partie semblable à celle précédemment décrite en référence à la figure 4. On a donc utilisé les mêmes références numériques que sur la figure 4, avec un symbole prime, pour désigner des éléments de même nature agencés de la même manière. La cellule passe-bande de la figure 5 diffère de la cellule passe-bas de la figure 4 en ce que le condensateur de charge 74', au lieu de recevoir le signal d'entrée Y1 de la cellule, est relié au potentiel MC par l'intermédiaire d'un commutateur 100, et en ce que le signal d'entrée Y1 est adressé à l'entrée négative de l'amplificateur opérationnel 70' par l'intermédiaire d'un condensateur 102. Le commutateur 100, qui remplace le commutateur 98, est commandé par le signal d'horloge H2 de manière à être fermé uniquement lorsque le signal H2 est actif (H2=1). Cette cellule passe-bande 64 a une fonction de transfert de la forme

$$H_{BP}(z) = \frac{-C_{W2}C_{G2}+C_{W2}C_{G2}z}{1+(-2+C_{W2}C_{Q2}+C_{W2}^2)z+(1-C_{W2}C_{Q2})z^2}$$

où $C_{W2}$ désigne la capacité des condensateurs de charge 74', 84', $C_{G2}$ désigne la capacité du condensateur d'entrée 102, et $C_{Q2}$ désigne la capacité du condensateur 90'. Ces capacités $C_{W2}$, $C_{G2}$ et $C_{Q2}$ s'entendent comme étant normalisées relativement à la capacité des condensateurs d'intégration 72', 82'.

On peut optimiser le comportement des cellules à capacités commutées 62, 64 en recherchant les coefficients des fonctions de transfert qui minimisent la distorsion de phase. Dans l'exemple particulier considéré précédemment, on peut ainsi retenir une cellule passe-bas 62 d'ordre 2 ayant une fréquence de coupure de 93,5 kHz et un coefficient de surtension de 4, et une cellule passe-bande 64 d'ordre 2 ayant une fréquence de coupure de 108,9 kHz et un coefficient de surtension de 4,7. Avec une fréquence d'échantillonnage de 2,7875 MHz et des cellules ayant les structures représentées sur les figures 4 et 5 avec des capacités d'intégration de 5 pF, ces fonctions de transfert peuvent être obtenues avec les valeurs numériques suivantes : $C_{G2}$=1 pF, $C_{W2}$=1,218 pF, $C_{Q2}$=1,042 pF, $C_{W1}$=1,048 pF, et $C_{Q1}$=1,227 pF.

Le spectre du signal de sortie Y2 du dispositif 60 à capacités commutées présente des raies à haute fréquence dues à la fréquence d'échantillonnage et à ses harmoniques. Un filtre passe-bas 110 est prévu pour éliminer ces raies à haute fréquence (figure 1). Ce filtre 110 consiste en un réseau RC d'ordre 1 comprenant, entre l'entrée recevant le signal Y2 et la borne de référence au potentiel MC, une résistance 112, un condensateur 114 et une résistance 116 montés en série. Le signal de sortie du filtre 110 est constitué par la tension HP-HM aux bornes du condensateur 114.

Comme le filtre passe-bas 110 introduit un certain déphasage, il est prévu un autre filtre passe-bas 120 de constitution identique traitant le signal Y0. Ce filtre 120 comprend une résistance 122, un condensateur 124 et une résistance 126 de caractéristiques aussi proches que possible que celles des composants 112, 114, 116 du filtre 110, et agencés de la même manière. La tension LP-LM aux bornes du condensateur 124 constitue le signal de sortie du filtre 120.

Le signal Y0 est de la forme cos(2πft), avec la fréquence f de la forme $f_T+\Delta f$, $\Delta f$ représentant la modulation de fréquence du signal radio d'entrée autour de la fréquence intermédiaire $f_I$. Dans ces conditions, la tension de sortie HP-HM du filtre passe-bas 110 est proportionnelle à cos(2πft+φ(Δf)+ψ(f)), où φ(Δf) désigne le déphasage produit par le dispositif déphaseur à capacités commutées 60, qui varie de façon linéaire avec la fréquence autour de la fréquence de transposition, et ψ(f) désigne le déphasage introduit par le filtre passe-bas 110 à la fréquence f. La tension de sortie LP-LM du filtre passe-bas 120 est proportionnelle à cos(2πft+ψ(f)). En multipliant les tensions HP-HM et LP-LM, on obtient alors un signal proportionnel cos(4πft+φ(Δf)+2ψ(f))+cos(φ(Δf)). Un filtrage passe-bas permet d'éliminer le premier terme pour ne conserver dans le signal de sortie en bande de base Z que le second terme porteur d'information, proportionnel à cos(φ(Δf)).

Le démodulateur représenté sur la figure 1 comprend ainsi des moyens de mélange constitués par un multiplieur 130 et par un filtre passe-bas 132 produisant le signal de sortie en bande de base Z à partir du signal de sortie HL du multiplieur 130. Le filtre passe-bas 132 peut simplement consister en un réseau RC.

Le multiplieur 130 a par exemple la structure représentée sur la figure 6. Il s'agit d'une structure de cellule de Gilbert très semblable à celle représentée sur la figure 2. En conséquence, on a utilisé les mêmes références numériques que sur la figure 2, avec le signe "'", pour désigner des composants analogues. Les bases des transistors npn 22', 24' du premier étage de la cellule de Gilbert reçoivent respectivement la tension LP présente entre la résistance 122 et le condensateur 124 du filtre passe-bas 120, et la tension LM présente entre le condensateur 124 et la résistance 126 du filtre passe-bas 120. Les grilles des transistors NMOS 28', 30' du second étage de la cellule de Gilbert reçoivent la tension HP présente entre la résistance 112 et le condensateur 114 du filtre passe-bas 110. Les grilles des transistors NMOS 26', 32' du second étage de la cellule de Gilbert reçoivent la tension HM présente entre le condensateur 114 et la résistance 116 du filtre passe-bas 110. La tension de sortie HL du multiplieur est disponible sur les drains des transistors NMOS 28' et 32'.

Pour régler l'amplitude du signal de sortie HL ou Z, on prévoit avantageusement que le générateur de courant 20' du multiplieur 130 délivre un courant dépendant d'un signal de commande de gain GS. Un tel réglage permet notamment de tenir compte de différentes largeurs de bande possibles pour des canaux de communication (par exemple 12,5 kHz et 25 kHz dans le cas des normes CT0).

## Revendications

**1.** Circuit démodulateur pour traiter un signal d'entrée (XP, XM) présentant une modulation de fréquence autour d'une fréquence intermédiaire ($f_I$) et produire un signal de sortie en bande de base (Z) représentatif de ladite modulation, caractérisé en ce qu'il comprend :

des premiers moyens (10,12) de mélange entre le signal d'entrée (XP, XM) et au moins une onde (QR, QM) de fréquence prédéterminée ($f_0$) pour produire un premier signal (Y0) présentant ladite modulation de fréquence autour d'une fréquence de transposition ($f_T$) égale à la différence entre la fréquence intermédiaire et ladite fréquence prédéterminée ;

des moyens déphaseurs à capacités commutées (60) auxquels est appliqué le premier signal (Y0), pour produire un second signal (Y2) présentant, par rapport au premier signal, un déphasage variant de façon sensiblement linéaire avec la fréquence autour de la fréquence de transposition ;

un premier filtre passe-bas (110) auquel est appliqué le second signal (Y2) pour éliminer des composantes à haute fréquence du second signal ;

un second filtre passe-bas (112) sensiblement identique au premier filtre passe-bas, auquel est appliqué le premier signal (Y0) ; et

des seconds moyens de mélange (130,132) entre des signaux (HP-HM, LP-LM) respectivement produits par les premier et second filtres passe-bas (110,112) pour délivrer le signal de sortie en bande de base (Z).

**2.** Circuit démodulateur selon la revendication 1, caractérisé en ce que les premiers moyens de mélange comprennent un multiplieur (10) faisant le produit entre le signal d'entrée (XP, XM) et ladite onde de fréquence prédéterminée (QP, QM), et un filtre passe-bas (12) d'ordre au moins égal à 3 pour produire le premier signal (Y0) à partir de la sortie (XQ) du multiplieur (10).

**3.** Circuit démodulateur selon la revendication 2, caractérisé en ce que la fréquence intermédiaire ($f_I$) étant comprise entre 440 et 500 kHz, la fréquence de transposition ($f_T$) est comprise entre 80 et 200 kHz, et ledit filtre passe-bas (12) d'ordre au moins égal à 3 a une fréquence de coupure comprise entre 200 et 300 kHz.

**4.** Circuit selon l'une quelconque des revendications 1 à 3, caractérisé en ce que les moyens déphaseurs à capacités commutées comprennent une cellule (62) de filtrage passe-bas d'ordre 2 à capacités commutées et une cellule (64) de filtrage passe-bande d'ordre 2 à capacités commutées montées en série.

**5.** Circuit selon l'une quelconque des revendications 1 à 4, caractérisé en ce que les premier et second filtres passe-bas (110, 112) sont des réseaux RC d'ordre 1.

**6.** Circuit selon l'une quelconque des revendications 1 à 5, caractérisé en ce que les seconds moyens de mélange comprennent un multiplieur (130) faisant le produit entre les signaux (HP-HM, LP-LM) produits par les premier et second filtres passe-bas (110, 112), et un filtre passe-bas (132) pour produire le signal de sortie en bande de base (Z) à partir d'un signal de produit (HL) délivré par le multiplieur (130).

**7.** Circuit selon la revendication 6, caractérisé en ce que ledit multiplieur (130) comporte des moyens (20') pour régler l'amplitude du signal de produit (HL) sur la base d'un signal de commande de gain (GS).

**Patentansprüche**

**1.** Demodulationsschaltung zur Verarbeitung eines Eingangssignals (XP, XM), welches eine Frequenzmodulation um eine Zwischenfrequenz ($f_I$) herum aufweist, und zum Erzeugen eines für diese Modulation repräsentativen Ausgangssignals im Basisband (Z), dadurch gekennzeichnet, daß sie aufweist:

erste Einrichtungen (10, 12) zum Mischen zwischen dem Eingangssignal (XP, XM) und mindestens einer Welle (QR, QM) mit einer vorgegebenen Frequenz ($f_0$) zum Erzeugen eines ersten Signals (Y0), welches diese Frequenzmodulation um eine Transpositionsfrequenz ($f_T$) herum aufweist, die gleich der Differenz zwischen der Zwischenfrequenz und der vorgegebenen Frequenz ist;

eine Phasenschiebereinrichtung (60) mit geschalteten Kapazitäten, an welche das erste Signal (Y0) angelegt wird, zum Erzeugen eines zweiten Signals (Y2), welches in Bezug auf das erste Signal eine Phasenverschiebung aufweist, die im wesentlichen linear mit der Frequenz um die Transpositionsfrequenz herum variiert;

ein erstes Tiefpaß-Filter (110), an welches das zweite Signal (Y2) angelegt wird, zum Eliminieren der Hochfrequenzkomponenten des zweiten Signals;

ein mit dem ersten Tiefpaß-Filter im wesentlichen identisches zweites Tiefpaß-Filter (112), an welches das erste Signal (Y0) angelegt wird; und

zweite Einrichtungen (130, 132) zum Mischen zwischen Signalen (HP-HM, LP-LM), die von dem ersten bzw. dem zweiten Tiefpaß-Filter (110, 112) erzeugt wurden, um das Ausgangssignal im Basisband (Z) auszugeben.

**2.** Demodulationsschaltung nach Anspruch 1, dadurch gekennzeichnet, daß die ersten Mischeinrichtungen einen Multiplizierer (10) aufweisen, der das Produkt aus dem Eingangssignal (XP, XM) und der Welle mit einer vorgegebenen Frequenz (QP, QM) erstellt, sowie ein Tiefpaß-Filter (12) mindestens 3. Ordnung zum Erzeugen des ersten Signals (Y0) ausgehend von dem Ausgang (XQ) des Multiplizierers (10).

**3.** Demodulationsschaltung nach Anspruch 2, dadurch gekennzeichnet, daß die Zwischenfrequenz ($f_I$) zwischen 440 und 500 kHz liegt, die Transpositionsfrequenz ($f_T$) zwischen 80 und 200 kHz liegt, und das Tiefpaßfilter (12) mindestens 3. Ordnung eine zwischen 200 und 300 kHz liegende Grenzfrequenz besitzt.

**4.** Schaltung nach einem der Ansprüche 1 bis 3, dadurch gekennzeichnet, daß die Phasenschiebereinrichtung mit geschalteten Kapazitäten eine Tiefpaßfilterzelle (62) 2. Ordnung mit geschalteten Kapazitäten und eine Paßbandfilterzelle (64) 2. Ordnung mit geschalteten Kapazitäten in Reihenschaltung aufweist.

**5.** Schaltung nach einem der Ansprüche 1 bis 4, dadurch gekennzeichnet, daß das erste und das zweite Tiefpaß-filter (110, 112) RC-Netzwerke 1. Ordnung sind.

**6.** Schaltung nach einem der Ansprüche 1 bis 5, dadurch gekennzeichnet, daß die zweiten Mischeinrichtungen einen Multiplizierer (130) aufweisen, der das Produkt aus den von dem ersten bzw. dem zweiten Tiefpaßfilter (110, 112) erzeugten Signalen (HP-HM, LP-LM) erzeugt, sowie ein Tiefpaß-Filter (132) zum Erzeugen des Ausgangssignals im Basisband (Z) ausgehend von einem Produktsignal (HL), das von dem Multiplizierer (130) ausgegeben wird.

**7.** Schaltung nach Anspruch 6, dadurch gekennzeichnet, daß der Multiplizierer (130) Einrichtungen (20') zum Regulieren der Amplitude des Produktsignals (HL) auf der Grundlage eines Verstärkungs-Steuersignals (GS) aufweist.

## Claims

1. Demodulator circuit for processing an input signal (XP, XM) exhibiting a frequency modulation about an intermediate frequency ($f_I$) and for producing a baseband output signal (Z) representative of said modulation, characterized in that it comprises:

   first mixing means (10,12) for mixing the input signal (XP, XM) and at least one wave (QR, QM) of predetermined frequency ($f_0$) in order to produce a first signal (Y0) exhibiting said frequency modulation about a transposition frequency ($f_T$) equal to the difference between the intermediate frequency and said predetermined frequency;
   switched-capacitor phase-shifter means (60) to which the first signal (Y0) is applied in order to produce a second signal (Y2) exhibiting, with respect to the first signal, a phase-shift varying in a manner substantially linear with frequency about the transposition frequency;
   a first low-pass filter (110) to which the second signal (Y2) is applied in order to eliminate high-frequency components from the second signal;
   a second low-pass filter (112) substantially identical to the first low-pass filter, to which the first signal (Y0) is applied; and
   second mixing means for mixing (130,132) signals (HP-HM, LP-LM) produced by the first and second low-pass filters (110,112) respectively, in order to deliver the baseband output signal (Z).

2. Demodulator circuit according to Claim 1, characterized in that the first mixing means comprise a multiplier (10) forming the product between the input signal (XP, XM) and said wave of predetermined frequency (QP, QM), and a low-pass filter (12) of order at least equal to 3 for producing the first signal (Y0) from the output (XQ) from the multiplier (10).

3. Demodulator circuit according to Claim 2, characterized in that with the intermediate frequency ($f_I$) lying between 440 and 500 kHz, the transposition frequency ($f_T$) lies between 80 and 200 kHz, and said low-pass filter (12) of order at least equal to 3 has a cutoff frequency of between 200 and 300 kHz.

4. Circuit according to any one of Claims 1 to 3, characterized in that the switched-capacitor phase-shifter means comprise a low-pass switched-capacitor filtering cell (62) of order 2 and a band-pass switched-capacitor filtering cell (64) of order 2 mounted in series.

5. Circuit according to any one of Claims 1 to 4, characterized in that the first and second low-pass filters (110, 112) are RC networks of order 1.

6. Circuit according to any one of Claims 1 to 5, characterized in that the second mixing means comprise a multiplier (130) forming the product between the signals (HP-HM, LP-LM) produced by the first and second low-pass filters (110, 112), and a low-pass filter (132) for producing the baseband output signal (Z) from a product signal (HL) delivered by the multiplier (130).

7. Circuit according to Claim 6, characterized in that said multiplier (130) includes means (20') for adjusting the amplitude of the product signal (HL) on the basis of a gain control signal (GS).

FIG.1.

FIG.2.

# FIG.3.

# FIG.6.

FIG.4.

FIG.5.